Europäisches Patentamt

European Patent Office

Office européen des brevets

(19)

(11) Publication number: **0 202 871**
**B1**

(12) **EUROPEAN PATENT SPECIFICATION**

(45) Date of publication of patent specification :
09.08.89

(21) Application number : 86303714.9

(22) Date of filing : 15.05.86

(51) Int. Cl.⁴ : **B 41 J   3/10**, B 41 J 29/00

(54) A printing head drive apparatus for a printer.

(30) Priority : 16.05.85 JP 102751/85

(43) Date of publication of application :
26.11.86 Bulletin 86/48

(45) Publication of the grant of the patent :
09.08.89 Bulletin 89/32

(84) Designated contracting states :
DE FR GB

(56) References cited :
EP—A— 0 100 388
GB—A— 1 558 765

(73) Proprietor : Oki Electric Industry Company, Limited
7-12, Toranomon 1-chome Minato-ku
Tokyo 105 (JP)

(72) Inventor : Tanuma, Jiro c/o Oki Electric Industry Co.
Ltd.
7-12, Toranomon 1-chome
Minato-ku Tokyo 105 (JP)

(74) Representative : Boydell, John Christopher et al
Stevens, Hewlett & Perkins 5 Quality Court Chancery
Lane
London, WC2A 1HZ (GB)

## Description

The present invention relates to a printer for printing characters, symbols, and patterns etc., and more particularly to a drive apparatus for a printing head adapted to be mounted on such a printer.

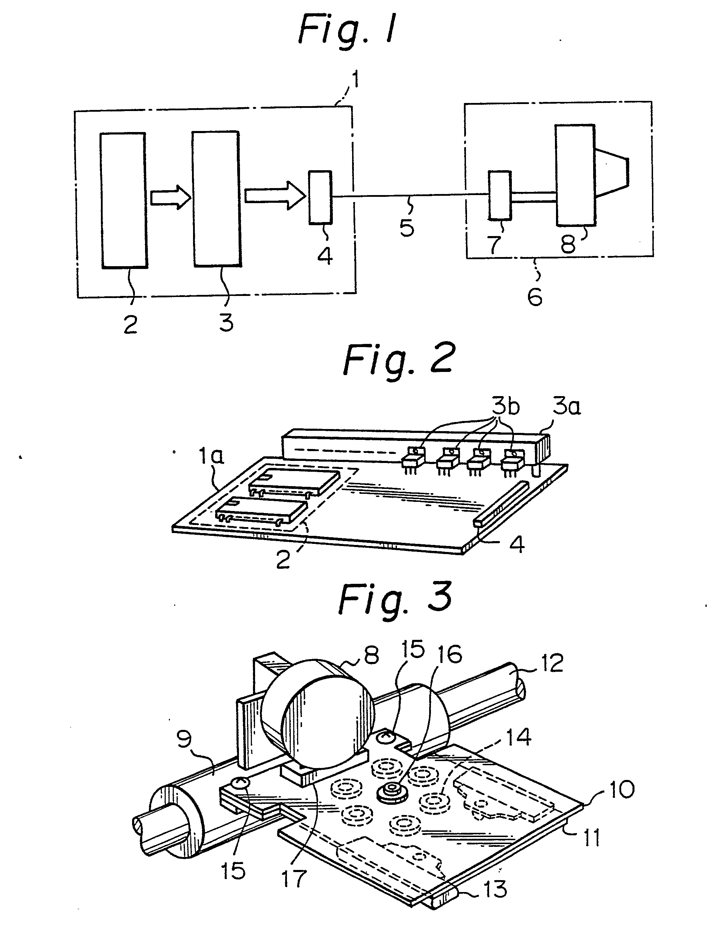

Printers are widely employed as output devices in various information processing apparatuses such for example as peripheral units of electronic computers terminal equipment connected with telephone lines and with the development of electronics many features have been concentrated on terminal equipment and peripheral units to miniaturise them, and reduce their weight as well as their power consumption. Likewise, a great deal of effort has been exerted to enable printers to act as output devices. In particular, for printing heads for use in such printers various systems have been developed for practical use. For example, a known printing head for a thermal printer comprises a plurality of micro heating elements, seven longitudinally and five transversely, provided on a ceramic substrate. Another known type of printing head for dot-wire printer includes seven printing wires longitudinally and is driven by electromagnetic force. Referring to Figure 1 of the accompanying drawings there is shown a drive apparatus for driving a dot printing head for use in such a known printer, and comprising a control unit 1 consisting of a controller 2 including 2 microprocessors etc., a drive circuit 3 connected with the controller 2 including drive elements such as transistors, and a connector 4 connected with the drive circuit 3. The connector 4 is connected with a connector 7 provided on a carriage 6 via a connecting cord 5. The carriage 6 carries the connector 7 and a printing head 8 connected with the connector 7. The printing head 8 is intended for a dot-wire printer, such as described above. Accordingly, printing wires arranged on the printing head 8 are driven selectively, while permitting the carriage 6 to be moved along a printing line, with the aid of the drive circuit 3 which operates in accordance with instructions issued by the controller 2 in order to cause any characters arranged in a 7 x 5 dot matrix to be printed. Referring now to Figure 2 of the accompanying drawings there is shown the structural arrangement of the drive apparatus of the printing head mounted on the printer. The drive apparatus comprises a drive element 3b which is mounted by means of screws on a heat sink 3a which acts as a radiator, and the heat sink 3a, controller 2, and connector 4 are mounted on a printed circuit board 1a which forms a prescribed electric circuit. However, such a prior circuit suffers from the drawback that since it has only a printing head, an object to be driven, mounted on the side of the carriage, a larger mounting space for the drive elements is required on that side of the control unit required correspondingly thereto. More particularly, printers needed to produce a higher printing quality must have many printing wires. Accordingly, such a printer must include as many drive elements as there are printing wires and this thus presents severe problems to be solved. In addition, printing heads which use such dot wires require more electric power to be consumed in their drive elements. Therefore, heat radiation from the drive elements cannot be neglected. It is thus necessary to reduce the influence of heat on the controller, etc., provided on the same circuit board by mounting heat sinks and cooling fans.

The present invention seeks to provide a simply-structured and miniaturised printer which is not so affected by heat radiation from the drive elements of the drive circuit and which provides a mounted structure of the drive circuit for the printing head not requiring heat sinks and cooling fans as cooling means for the drive elements.

In accordance with the invention there is provided a printing head drive apparatus for a printer, said apparatus comprising a carriage having a printing head thereon, said printing head including a plurality of drive elements, said carriage being movable along a printing line under the control of a controller acting on a drive circuit including said drive elements, and wherein :

a) said carriage is equipped with a thermally conducting plate, and

b) said drive circuit is mounted on said plate. With the arrangement described above, the drive circuit of the printer, being the chief heat radiator, is mounted on the thermally conducting plate acting as a heat sink on the carriage. A fixed printed circuit board accordingly requires no cooling means. In addition, complete separation of the controller and the heat generating parts from each other, which is assured in the present invention, improves the reliability of the apparatus.

In order that the invention may be better understood, an embodiment thereof will now be described by way of example only and with reference to the accompanying drawings in which :

Figure 1 is a block diagram illustrating a known printing head drive apparatus ;

Figure 2 is a view illustrating the structure of the prior control unit ;

Figure 3 is an exemplary carriage structure according to the present invention ;

Figure 4 is a perspective view of the structure of Figure 3, viewed from the rear surface thereof ;

Figure 5 is a cross sectional view of the structure of Figure 2 ; and

Figure 6 is a block diagram illustrating an embodiment of a head drive apparatus according to the present invention.

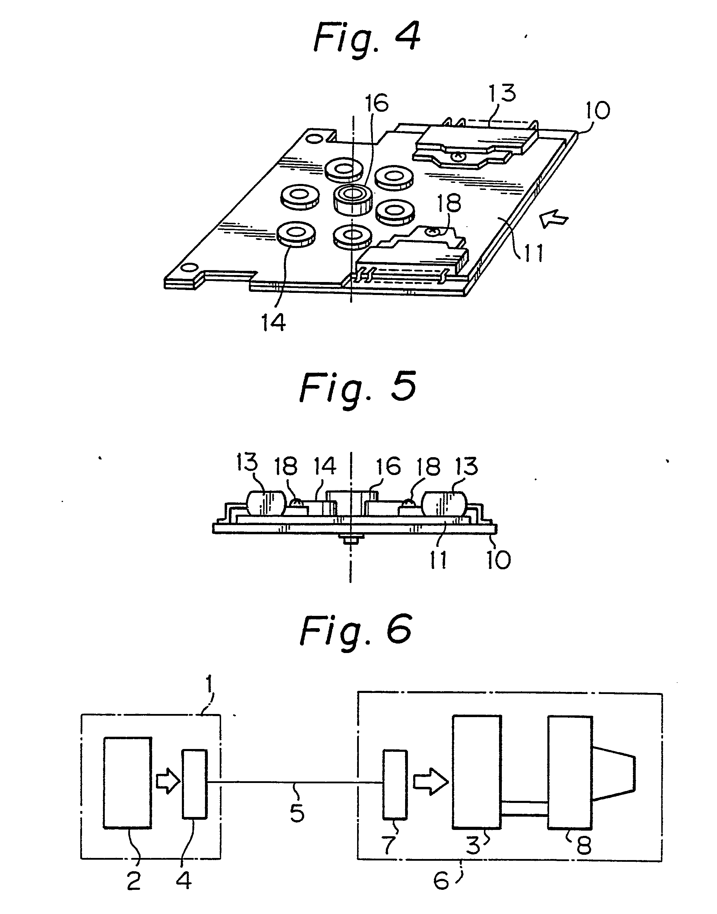

Let us describe here an embodiment of a drive apparatus of a printing head for a printer according to the present invention with reference to Figures 3 to 6. The basic arrangement of the head drive circuit is illustrated in Figure 6, but the arrangement is very similar to that described above with reference to Figure 1. Accordingly, description thereof will be neglected here except to note that like members have been assigned like reference numerals.

Referring now to Figure 3 illustrating a carriage of a printer for printing a line of characters while moving a printing head in a printing direction. The carriage comprises an aluminium diecast carriage frame 9 for fixing a space motor assembly including a printing head 8 and a printing drive circuit, both being movable in the direction of printing by making use of a shaft 12. Reference 10 is a printed circuit board for electrically mounting the components of the motor assembly as well as those of the printing drive circuit and also connecting them with each other. Reference 11 is a thermally conducting plate, for example of iron, 12 is a shaft, 13 is a printing head drive element, 14 a space motor coil, 15 are screws for fixing the motor assembly composed of the printed circuit board 10 and the iron plate 11 onto the carriage frame 9. Reference 16 is a bearing for the space motor shaft, 17 is a connector for electrically connecting the circuit board with the printing head 8, and 18 are screws which are used to attach radiating fins for the printing head drive elements 13 onto the iron plate 11.

With the arrangement described above, the side of the control unit is constructed with only a control section without having any heat generating parts such as the drive elements, etc. Accordingly, the printing head drive circuit according to the present invention assures high density mounting and enables the drive circuit to be miniaturised in order to reduce the cost.

Since the printing head drive elements 13 mounted on the side of the carriage have their radiating fins fixed on the iron plate 11 with the screws as shown in Figure 3, the iron plate 11 acts as a heat radiating plate for the printing head drive element 13. In addition, since the iron plate 11 is connected with and fixed on the aluminium diecast carriage frame 9, which exhibits extensive radiating effect, by means of the screws 15 along their surfaces, the carriage frame 9 also acts as a heat sink. Furthermore, the shaft 12 also exerts a heat sink effect since it has only the thickness thereof ranging from about 0.5 mm to 1 mm and furthermore it makes surface-contact with the carriage frame 9 via a resin bush (not shown) fitted in the inner part of the carriage frame 9.

It should be noted here that the motor coil 14 and the printing head 8 also serve as radiating parts likewise the printing head drive elements 13. However, since the whole structure of the carriage exhibits a heat sink effect as described above, it is unnecessary to mount any particular heat sink and/or cooling fan as a cooling means thereon. Moreover, since the carriage moves while effecting a printing operation, the air stream so produced thereover may also be available as a cooling means.

In addition, since the whole arrangement of the printer is completely independently divided into a control section and a drive circuit, generating much heat, and a load section, the reliability of the drive circuit may be sharply improved.

Furthermore, since the drive circuit is adapted to be mounted on the side of an object to be driven and thereby radiate heat generated therein by making use of a metal base, etc., disposed on the side of the object to be driven, it may also be profitably employed for a space motor drive circuit of the printer, etc.

## Claims

1. A printing head drive apparatus for a printer, said apparatus comprising a carriage (6) having a printing head (8) thereon, said printing head including a plurality of drive elements (13), said carriage being movable along a printing line under the control of a controller (1) acting on a drive circuit (3) including said drive elements, and wherein :

a) said carriage (6) is equipped with a thermally conducting plate (11), and

b) said drive circuit (3) is mounted on said plate (11).

2. Apparatus according to claim 1 wherein said thermally conducting plate is a metal plate.

3. Apparatus as claimed in either one of claims 1 or 2 further comprising :

c) a thermally conducting carriage frame (9) mounted on said carriage (6) and

d) a thermally conducting shaft (12) for guiding the movement of said carriage frame (9).

## Patentansprüche

1. Druckkopf-Antriebsvorrichtung für einen Drucker, die einen Wagen (6) mit einem hierauf befindlichen Druckkopf (8) umfaßt, wobei der Druckkopf eine Mehrzahl von Antriebselementen (13) umfaßt und der Wagen entlang einer Druckzeile unter der Steuerung eines Steuerapparates (1), der auf eine Antriebsschaltung (3) einwirkt, welche die Antriebselemente umfaßt, bewegbar ist, und wobei :

a) der Wagen (6) mit einer wärmeleitfähigen Platte (11) ausgerüstet ist, und

b) die Antriebsschaltung (3) auf der Platte (11) befestigt ist.

2. Vorrichtung nach Anspruch 1, wobei die wärmeleitfähige Platte eine Metallplatte ist.

3. Vorrichtung nach Anspruch 1 oder 2, die weiterhin folgendes umfaßt :

c) einen wärmeleitfähigen Wagenträger (9), der am Wagen befestigt ist, und

d) eine wärmeleitfähige Welle (12) zur Bewegungsführung des Wagenträgers (9).

## Revendications

1. Dispositif d'entraînement d'une tête d'impression pour une imprimante, ledit dispositif comprenant un chariot (6) portant une tête (8) d'impression, ladite tête d'impression comprenant plusieurs éléments de puissance (13), ledit chariot étant mobile le long d'une ligne d'impression sous la commande d'un élément (1) de commande agissant sur un circuit (3) de puissance comprenant lesdits éléments de puissance, et dans lequel :

a) ledit chariot (6) est équipé d'une plaque (11) conductrice de la chaleur, et

b) ledit circuit de puissance (3) est monté sur ladite plaque (11).

2. Appareil selon la revendication 1, dans lequel ladite plaque conductrice de la chaleur est une plaque métallique.

3. Appareil selon l'une des revendications 1 ou 2, comprenant en outre :

c) un châssis (9) de chariot conducteur de la chaleur monté sur ledit chariot (6) et

d) un arbre (12) conducteur de la chaleur destiné à guider le mouvement dudit châssis (9) de chariot.

EP 0 202 871 B1

# Fig. 1

# Fig. 2

# Fig. 3

## Fig. 4

## Fig. 5

## Fig. 6